# FASCICULE DE BREVET EUROPEEN

(11) **EP 2 226 937 B1**
(45) Date de publication et mention de la délivrance du brevet: **08.02.2012**
(21) Numéro de dépôt: 09181029.1
(22) Date de dépôt: 30.12.2009
(51) Int. Cl.: H03K 17/00

(54) **Interrupteur analogique**
Analogschalter
Analog switch

(30) Priorité: 03.03.2009 FR 0951320
(43) Date de publication de la demande: 08.09.2010
(73) Titulaire: STMicroelectronics (Grenoble) SAS, 38000 Grenoble (FR)
(72) Inventeur: Ramet, Serge, 38560 Jarrie (FR)
(74) Mandataire: de Beaumont, Michel

(56) Documents cités:
- EP-A- 0 720 270
- WO-A-2007/051178
- FR-A- 2 509 931
- US-A- 4 093 874
- US-A1- 2003 016 072
- US-A1- 2008 231 341

## Description

### Domaine de l'invention

La présente invention concerne, de façon générale, les dispositifs électroniques et, plus particulièrement, un interrupteur analogique réalisé à partir d'un transistor MOS.

### Exposé de l'art antérieur

La figure 1 représente un interrupteur analogique 1 décrit dans le document US-A-5 933 046 (B2895 - ST/95-GR2-084).

Cet interrupteur est apte à fonctionner dans des circuits alimentés en basse tension, par exemple, 3 volts. Il comprend un transistor MOS à canal P M1. Le drain D1 et la source S1 du transistor M1 définissent les bornes U1 et U2 d'entrée et de sortie de l'interrupteur 1. Le substrat ou caisson (bulk) B1 est connecté, par l'intermédiaire d'une source de courant I1 constant, à une borne d'alimentation Vcc ayant un potentiel positif. La grille G1 du transistor M1 est commandée par une source de tension, non représentée. Par exemple, cette grille G1 reçoit un signal logique Vg dont les deux niveaux définissent les états conducteur et bloqué du transistor M1.

Pour que l'interrupteur analogique présente une excursion maximale en tension, on cherche à appliquer à la borne de substrat B1 le potentiel le plus élevé des potentiels des deux bornes U1 et U2. S'agissant d'un interrupteur analogique, la borne de sortie U2 est en effet susceptible de présenter un potentiel tantôt supérieur, tantôt inférieur, au potentiel de la borne d'entrée U1 selon le sens de variation de ce potentiel d'entrée.

Des transistors M2 et M3 sont montés symétriquement par rapport à l'interrupteur analogique 1. Leurs grilles respectives G2 et G3 sont reliées aux bornes U1 et U2. Leurs sources S2, S3 sont reliées à un noeud commun N qui est lui-même relié à la masse par l'intermédiaire d'une source de courant I0 constant. Les drains D2, D3 des transistors M2 et M3 sont reliés à la borne d'alimentation Vcc. Enfin, un transistor M4 a sa grille G4 et son drain D4 reliés à la borne de substrat B1 du transistor M1 et sa source S4 reliée au noeud N. Les bornes de substrat B2 à B4 des transistors M2 à M4, représentés flottants, sont généralement reliées au potentiel GND.

Le fonctionnement d'un tel interrupteur analogique 1 est le suivant. Le noeud N est porté au plus élevé des potentiels des bornes U1 et U2, diminué d'une tension de seuil (de celle du transistor M2 ou M3 qui est y associée). Par exemple, si le potentiel de la borne U1 est supérieur au potentiel de la borne U2, le transistor M2 se comporte en transistor suiveur et reporte sur le noeud N le potentiel de la borne U1 diminué de la tension de seuil du transistor M2. Il en découle, d'une part, que le transistor M3 est bloqué (puisque sa tension grille-source devient positive) et, d'autre part, que le substrat B1 a un potentiel égal au potentiel du noeud N augmenté de la tension de seuil du transistor M4. Puisque les tensions de seuil des transistors M2 à M4 sont quasiment égales, le substrat B1 a un potentiel sensiblement égal au potentiel de la borne U1. Dans cette configuration, tout se passe comme si on effectue une connexion directe entre la borne B1 et la source S1 du transistor M1, minimisant de ce fait la tension de seuil du transistor M1.

Lorsque les bornes U1 et U2 présentent toutes les deux un potentiel inférieur à la tension de seuil des transistors M2 et M3, ces transistors deviennent bloqués. Le potentiel Vb de la borne de substrat B1 a alors une valeur minimale égale à la tension de seuil du transistor M4. Il en découle une augmentation de la valeur de la tension de seuil du transistor M1 générant une distorsion du signal recopié sur la borne U2. La linéarité de l'interrupteur analogique se dégrade pour des signaux de faible amplitude.

Par ailleurs, le fonctionnement de l'interrupteur requiert une source de tension extérieure pour appliquer sur la grille G1 un potentiel de commande Vg. Cela rend la configuration de cet interrupteur relativement complexe.

Le document US-A-2003/0016072 décrit un interrupteur analogique comprenant un transistor MOS principal reliant des bornes d'entrée et de sortie, deux transistors MOS en série reliant les bornes d'entrée-sortie, le point milieu de l'association en série étant relié au substrat du transistor principal et les grilles des trois transistors étant interconnectées.

Le document EP-A-0720270 décrit un commutateur analogique comprenant deux associations en série de transistors MOS entre des bornes d'entrée-sortie reliées par un transistor principal.

Les documents FR-A-2509931 et WO-A-2007/051178 décrivent d'autres circuits d'interrupteurs analogiques.

### Résumé

Il serait souhaitable de disposer d'un interrupteur analogique qui pallie tout ou partie des inconvénients de l' art antérieur.

En particulier, il serait souhaitable de disposer d'un interrupteur analogique qui ait un fonctionnement linéaire sur une plage de fonctionnement aussi étendue que possible.

Il serait également souhaitable de disposer d'un interrupteur analogique de constitution simple.

Ainsi, un objet d'un mode de réalisation de la présente invention prévoit un interrupteur analogique comprenant:
au moins un premier transistor MOS apte à transférer un signal appliqué sur une première borne vers une seconde borne ;
un circuit de connexion pour porter une borne de substrat dudit premier transistor à un potentiel fonction des potentiels des première et seconde bornes ; et caractérisé en ce qu'il comporte

un circuit d'asservissement comportant un deuxième transistor MOS comprenant une borne de commande connectée à la première borne, une borne de substrat et une première borne de conduction connectées à ladite première borne d'alimentation et à la borne de commande dudit premier transistor, par l'intermédiaire d'une source de courant constant, et une deuxième borne de conduction connectée à une deuxième borne d'alimentation.

Selon un mode de réalisation de la présente invention, le circuit de connexion comporte un troisième et un quatrième transistors MOS montés en série entre deux bornes de conduction du premier transistor, les troisième et quatrième transistors ayant des bornes de commande reliées au circuit d'asservissement, et ayant chacun une borne de substrat et au moins une borne de conduction reliées à un premier noeud commun avec la borne de substrat du premier transistor.

Selon un mode de réalisation de la présente invention, un circuit auxiliaire connecté au circuit d'asservissement est prévu pour faire passer l'interrupteur analogique d'un état conducteur à un état bloqué.

Selon un mode de réalisation de la présente invention, le circuit auxiliaire comprend des cinquième et sixième transistors MOS, le cinquième transistor ayant une première borne de conduction connectée audit premier noeud commun, une borne de commande reliée à une borne d'entrée recevant un signal logique, et le sixième transistor ayant une borne de commande reliée à la borne d'entrée et une première borne de conduction reliée au circuit d'asservissement.

Selon un mode de réalisation de la présente invention, l'interrupteur comprend deux premiers transistors montés en série entre les deux première et seconde bornes et ayant chacun une borne de commande reliée au circuit d'asservissement.

Selon un mode de réalisation de la présente invention, le circuit auxiliaire comprend un septième transistor MOS connecté par sa borne de commande à la borne d'entrée, par sa première borne de conduction à un deuxième noeud commun aux deux premiers transistors et par sa deuxième borne de conduction à la deuxième borne d'alimentation.

Il est également prévu un circuit de commutation analogique de signaux comprenant au moins un interrupteur analogique, connecté à un convertisseur analogique/numérique.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, représente un interrupteur analogique selon l'art antérieur ;
la figure 2 est un schéma bloc d'un interrupteur analogique à transistors MOS selon un mode de réalisation de la présente invention ;
la figure 3 est un schéma électrique détaillé de l'interrupteur de la figure 2 ;
la figure 4 est un schéma électrique détaillé d'un interrupteur analogique selon un autre mode de réalisation de la présente invention ;
la figure 5 est un graphe comparant l'évolution, en fonction de la tension de mode commun, d'une résistance série de l'interrupteur analogique selon le mode de réalisation de la figure 4 et selon l'art antérieur ; et
la figure 6 représente, sous forme de blocs, un exemple d'application d'un interrupteur analogique à un circuit de commutation analogique.

### Description détaillée

Par souci de clarté, de mêmes éléments ont été désignés par de mêmes références aux différentes figures.

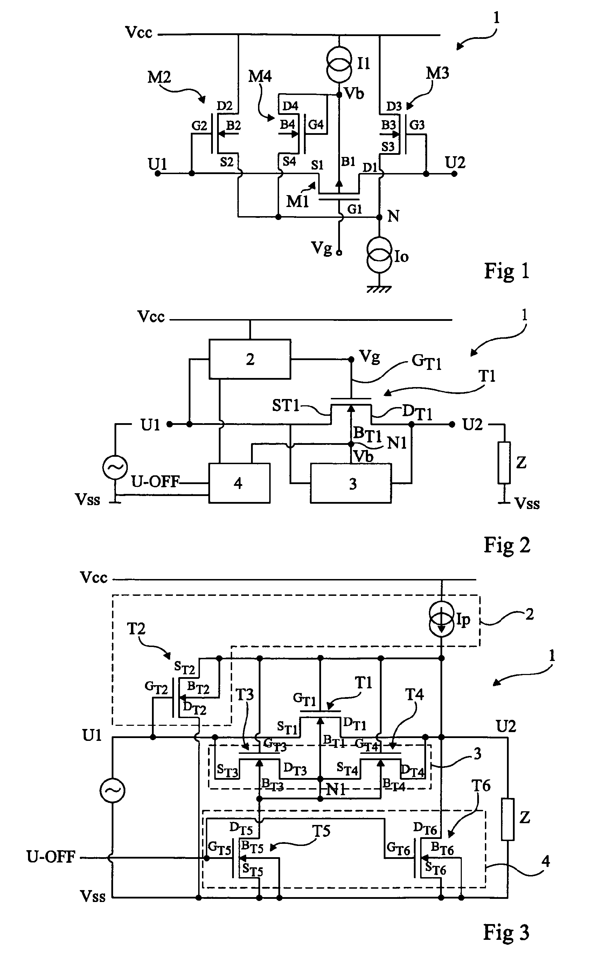

La figure 2 est un schéma bloc fonctionnel d'un mode de réalisation d'un interrupteur analogique 1.

L'interrupteur analogique 1 comporte un premier transistor MOS à canal N T1 entre une borne U1 (arbitrairement d'entrée) et U2 (arbitrairement de sortie) de l'interrupteur. Typiquement, la borne d'entrée U1 reçoit un signal analogique quelconque et la borne de sortie U2 est reliée à une charge Z, par exemple une charge capacitive, connectée à une borne d'alimentation Vss de potentiel bas, correspondant généralement à la masse GND.

Les bornes d'entrée et de sortie U1 et U2 de l'interrupteur analogique 1 sont représentées reliées respectivement à la source S_{T1} et au drain D_{T1} du transistor T1. La notion de source et de drain est arbitraire, les bornes du transistor jouant le rôle de source et de drain dépendant des potentiels respectifs des bornes U1 et U2. La grille G_{T1} du transistor T1 est reliée, par l'intermédiaire d'un circuit d'asservissement 2, à une borne d'alimentation Vcc de potentiel haut, par exemple 3 volts. Sa borne de substrat ou de caisson (bulk) B_{T1} est connectée à un noeud commun N1.

Le circuit 2 a pour rôle d'asservir une tension Vg de la grille G_{T1} du transistor T1 sur un signal analogique quelconque reçu sur la borne U1. Ce circuit d'asservissement 2 est réalisé de sorte que la tension entre la grille G_{T1} et la source S_{T1} du transistor T1 demeure constante et ceci indépendamment du signal analogique de la borne d'entrée U1 de l'interrupteur analogique 1.

Par ailleurs, entre les bornes U1 et U2 de l'interrupteur, est prévu un circuit de connexion 3 pour porter la borne de substrat B_{T1} du transistor T1 au potentiel le plus bas pris parmi les potentiels des bornes U1 et U2.

En outre, un circuit auxiliaire 4 est prévu entre le noeud commun N1 et la borne d'alimentation Vss. Ce circuit auxiliaire permet de commander l'interrupteur analogique 1 pour passer d'un état conducteur à un état bloqué en fonction d'un signal logique reçu sur, une borne d'entrée U_OFF du circuit auxiliaire 4.

La figure 3 est un schéma électrique détaillant un mode de réalisation des circuits d'asservissement 2, de connexion 3 et auxiliaire 4 de l'interrupteur analogique 1.

Le circuit d'asservissement 2 comprend, de préférence, un deuxième transistor T2, monté en transistor suiveur, et une source de courant Ip constant. La grille G_{T2} du transistor T2 est reliée à la borne U1 pour recevoir le signal analogique d'entrée. Son drain D_{T2} est relié à la borne d'alimentation Vss. Sa source S_{T2} et son substrat B_{T2} sont reliés à la grille G_{T1} du transistor T1. La source de courant Ip relie la grille G_{T1} à la borne d'alimentation Vcc.

Le transistor T2 et la source de courant Ip copient la tension du signal analogique en la décalant de la tension grille-source du transistor T2, rendue approximativement constante par la source de courant Ip, afin de maintenir constante la tension grille-source du transistor T1.

Le circuit de connexion 3 est réalisé par des troisième T3 et quatrième T4 transistors montés en série entre les bornes U1 et U2 de l'interrupteur analogique 1. Leurs grilles respectives G_{T3} et G_{T4} sont reliées à la grille G_{T1} du transistor T1 pour recevoir la même tension. La source S_{T3} du transistor T3 est reliée à la borne d'entrée U1. Son drain D_{T3} est relié à la source S_{T4} du quatrième transistor T4 pour former le noeud N1. Le drain D_{T4} du transistor T4 est relié à la borne U2. Les substrats B_{T3} et B_{T4} des transistors T3 et T4 sont reliés au substrat B_{T1} du transistor T1 et au noeud N2, lui-même connecté au circuit auxiliaire 4.

Les transistors T3 et T4 sélectionnent le potentiel le plus bas entre les potentiels des bornes U1 et U2 pour l'appliquer au substrat B_{T1} du transistor T1. Ils ont des tailles relativement petites par rapport à la taille du transistor T1 puisque le rôle des transistors T3 et T4 est d'assurer la polarisation du substrat B_{T1} au potentiel le plus bas des bornes U1 et U2 et non pas d'assurer le passage du courant de l'interrupteur analogique qui est préférentiellement conduit par le transistor T1. Par conséquent la taille du transistor T1 est choisie de sorte que sa résistance série Rdson soit faible.

Le circuit auxiliaire 4 reçoit, sur son entrée U_OFF, un signal logique à deux états. Par exemple, la borne d'entrée U_OFF reçoit un état bas pour désactiver le circuit auxiliaire 4 et rendre passant l'interrupteur analogique 1, et un état haut pour activer ce circuit 4 et bloquer l'interrupteur 1.

Le circuit auxiliaire 4 est réalisé par des cinquième T5 et sixième T6 transistors MOS de type N, de petite taille par rapport à la taille du transistor T1. Les grilles G_{T5} et G_{T6} des transistors T5 et T6 sont reliées à l'entrée U OFF. Les sources S_{T5} et S_{T6} des transistors T5 et T6 ainsi que leurs substrats B_{T5} et B_{T6} sont reliés à la borne d'alimentation Vss. Le drain D_{T5} du transistor T5 est relié au noeud N1 et le drain D_{T6} du transistor T6 est relié à la source de courant Ip.

Le fonctionnement de l'interrupteur analogique 1 est le suivant.

Pour activer l'interrupteur analogique 1, l'entrée U_OFF reçoit le niveau bas du signal logique. La borne de sortie U2, étant chargée par une charge capacitive Z, cette dernière stocke la valeur du signal appliqué à la borne U1 pris à un moment antérieur à la mise en état de conduction de l'interrupteur analogique 1.

On suppose, par exemple, que lorsque l'interrupteur analogique 1 est rendu conducteur, le potentiel à la borne U1 est de 0V, et le potentiel à la borne U2 est de 1V. Il en découle que le potentiel à la borne du substrat B_{T1} est de 0V (le plus bas potentiel entre les bornes U1 et U2). Les tensions source-substrat et grille-source du transistor T1 sont aussi égales à 0V. La tension drain-source de ce même transistor T1 est égale à 1V. Le potentiel des grilles des transistors T1, T3 et T4 est égal au potentiel de la borne U1 augmenté de la tension grille-source constante du transistor T2. Ainsi, les tensions grille-source des transistors T1 et T3 sont égales à cette tension grille-source du transistor T2. La tension grille-source du transistor T4 est égale à la tension grille-source du transistor T2 lorsque le potentiel de la borne U1 est inférieur au potentiel de la borne U2. Dans le cas contraire, cette tension est égale à la tension grille-source du transistor T2 augmentée de la différence entre les potentiels des deux bornes U1 et U2.

Lorsque le potentiel à la borne U1 augmente, la tension drain-source du transistor T1 diminue. Les tensions grille-source des transistors T1 et T3 restent constantes, égales à la tension grille-source du transistor T2. La tension grille-source du transistor T4 augmente. Le transistor T3 ou T4 qui a une tension grille-source positive, supérieure à sa tension de seuil et qui a un potentiel de drain ou source le plus bas entre les potentiels des bornes U1 et U2 est celui qui conduit le premier. Dans l'exemple ci-dessus, le transistor T3 conduit et tend à amener le potentiel du substrat B_{T1} vers celui de la borne U1. Le transistor T4 reste bloqué jusqu'à ce que sa tension grille-source soit supérieure à sa tension de seuil. Si, à l'inverse, on part d'un potentiel de la borne U2 égal à 0V et d'un potentiel de la borne U1 égal à 1V, les rôles des transistors T3 et T4 sont inversés.

La tension grille-source du transistor T1 étant constante, le potentiel de sa source augmente, le transistor T1 a tendance à diminuer le potentiel à la borne U2, en déchargeant la charge capacitive Z, pour que son drain D_{T1} soit au même potentiel que sa source S_{T1}.

Lorsque la tension drain-source du transistor T1 atteint une valeur limite nulle, on est en régime établi. Les potentiels aux bornes U1 et U2 atteignent également une valeur commune induite par la valeur nulle de la tension drain-source du transistor T1. En régime établi, les tensions grille-source des transistors T3 et T4 sont positives et de même valeur. Il en résulte que les deux transistors T3 et T4 sont conducteurs. Le potentiel au noeud N1 est égal à la valeur commune des potentiels des bornes U1 et U2. Par conséquent, la tension grille-source du transistor T1 devient constante. Les potentiels du substrat B_{T1} et de la source S_{T1} du transistor T1 sont égaux. Tout se passe comme si on effectue un court-circuit entre le substrat B_{T1} et la source S_{T1} de ce transistor, ce qui correspond à une configuration optimale puisque la tension de seuil du transistor T1 est alors minimale.

Ainsi, le signal d'entrée n'est pas restitué sur le substrat B_{T1} du transistor T1, évitant de reproduire, sur la borne U2, toute distorsion du signal présent sur la borne U1. Par conséquent, le transistor T1 présente des caractéristiques stables pour tout signal appliqué à la borne U1.

En outre, puisque quelles que soient l'amplitude et la fréquence du signal reçu sur la borne U1, les caractéristiques du transistor T1 demeurent inchangées, la stabilité de la tension source-grille du transistor T1 est assurée sur une large bande de fréquences. Cela permet à l'interrupteur analogique d'avoir une bonne linéarité ainsi qu'une rapidité de transfert de la borne U1 vers la borne U2.

Le fait d'asservir le potentiel de la grille G_{T1} du transistor T1 sur le signal reçu à la borne d'entrée U1 permet d'éviter que la résistance Rdson du transistor T1 ne soit modulée par le signal analogique d'entrée, et participe aussi à l'obtention d'une bonne linéarité de l'interrupteur analogique en fonction de la fréquence du signal d'entrée.

Lorsque l'interrupteur analogique 1 est mis en état de non conduction, c'est-à-dire que le signal appliqué à la borne d'entrée U_OFF est à son niveau haut, la grille G_{T1} du transistor T1 ainsi que son substrat B_{T1} sont portés au potentiel de la borne d'alimentation Vss.

Le potentiel des grilles G_{T5} et G_{T6} des transistors T5 et T6 est égal à celui de l'entrée U_OFF, ce qui les rend passants. Le noeud commun N1 est connecté à la borne d'alimentation Vss par l'intermédiaire du transistor T5, et les grilles G_{T1}, G_{T3} et G_{T4} des transistors T1, T3 et T4 sont connectées à la borne Vss par l'intermédiaire du transistor T6. Le substrat B_{T2} et la source S_{T2} du transistor T2 ainsi que la source du courant Ip sont connectés à la borne Vss par l'intermédiaire du même transistor T6. Les drains D_{T5} et D_{T6} des transistors T5 et T6 ramènent le noeud N1 et la source de courant Ip à la borne Vss. Par conséquent, tous les transistors ou les diodes associées à ces transistors sont bloqués. Il en découle que le couplage entre les bornes U1 et U2 est réduit.

Chacun des transistors T5 et T6 à l'état passant fournit une résistance de quelques dizaines de kilo-ohms qui ramène le potentiel du substrat B_{T1} du transistor T1 au potentiel GND. Il en découle une bonne isolation entrée-sortie de l'interrupteur analogique 1 uniquement limitée par le couplage capacitif natif intrinsèque aux transistors et aux connexions.

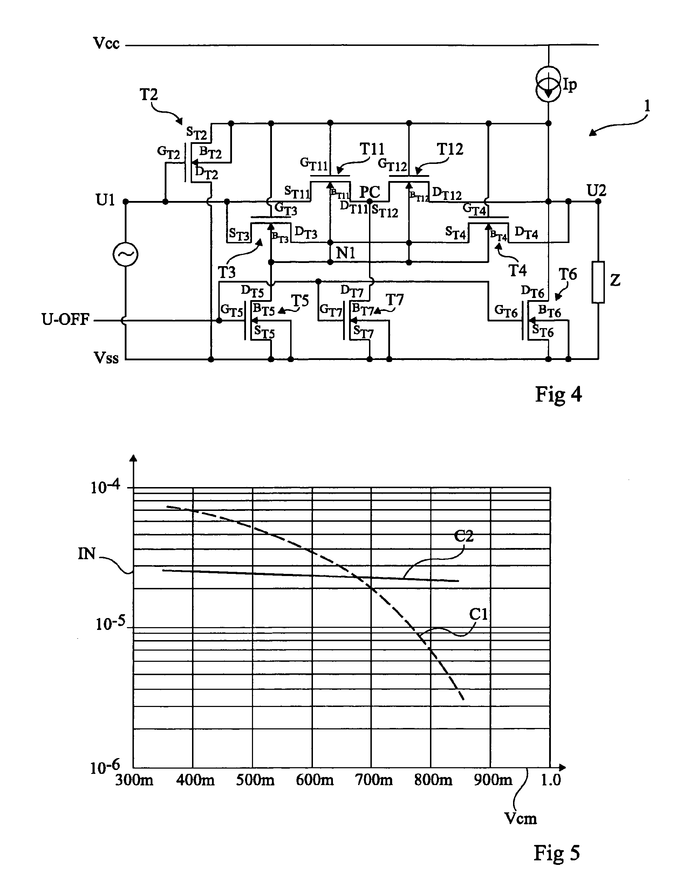

La figure 4 représente un autre mode de réalisation de l'interrupteur analogique.

Le transistor T1 du montage de la figure 3 est remplacé par deux transistors T11 et T12 montés en série entre les bornes d'entrée U1 et de sortie U2 de l'interrupteur analogique 1. La configuration des transistors T2 à T6 reste inchangée. Les grilles G_{T11} et G_{T12} des transistors T11 et T12 sont reliées à la source S_{T2} du transistor T2 et les substrats B_{T11} et B_{T12} de ces transistors sont reliés au noeud commun N1. La source S_{T11} du transistor T11 est reliée à la borne U1. Le drain D_{T12} du transistor T12 est relié à la borne U2. Le drain D_{T11} du transistor T11 ainsi que la source S_{T12} du transistor T12, définissant un noeud commun PC, sont reliés à la borne d'alimentation Vss par l'intermédiaire d'un septième transistor T7. La source S_{T7} et le substrat B_{T7} du transistor T7 sont reliés à la borne Vss. Sa grille G_{T7} est reliée aux grilles G_{T5} et G_{T6} des transistors T5 et T6 pour recevoir le même signal logique à deux états. Son drain D_{T7} est relié au noeud PC qui est porté au potentiel de la borne Vss lorsque le signal logique est à l'état haut, ce qui permet de réduire le couplage entre les bornes U1 et U2. On obtient alors une meilleure isolation.

La figure 5 compare l'évolution de la résistance série Rdson du transistor T1, entre un mode de réalisation de l'invention et l'état de la technique. La figure 5 représente l'évolution d'un courant d'entrée IN (exprimé en Ampères) par rapport à une tension en mode commun Vcm (exprimée en Volt).

Des courbes C1 et C2 illustrées sur la figure 5, on peut déduire l'évolution de la conductance du transistor T1, donc l'évolution de la résistance série Rdson en prenant l'inverse des valeurs de conductance. On remarque que, selon la courbe C1, la résistance série du transistor M1 de l'état de la technique n'est pas linéaire et varie fortement en fonction de la tension Vcm. Selon la courbe C2, la résistance Rdson des modes de réalisation de la présente invention est sensiblement linéaire indépendamment de la tension Vcm.

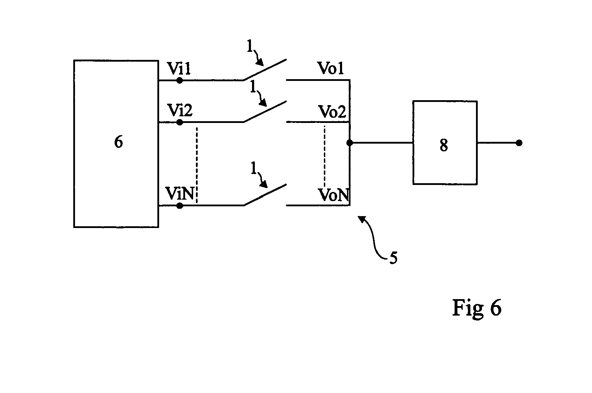

La figure 6 représente un exemple d'application de l'interrupteur analogique 1 dans un circuit de commutation analogique 5. Un bloc 7 de plusieurs interrupteurs analogiques 1 reçoit, d'un bloc d'entrée 6, des signaux d'entrée Vᵢ₁ à V_{iN} correspondant à un signal d'entrée quelconque reçu sur la borne d'entrée U1 de chaque interrupteur. Chaque interrupteur commute le signal reçu à son entrée Vᵢ₁ à V_{iN} qui lui est associée vers une borne de sortie V_{O1} à V_{ON} correspondante. Un bloc 8, par exemple, un convertisseur analogique/numérique, est relié aux sorties respectives du bloc 7.

Pour les circuits requérant une grande bande passante le mode de réalisation préféré de l'interrupteur analogique 1 du circuit de commutation 5 ci-dessus est celui de la figure 3. Pour les circuits requérant une grande isolation entre les noeuds U1 et U2 lorsque l'interrupteur est bloqué le mode de réalisation préféré de l'interrupteur analogique 1 du circuit de commutation 5 ci-dessus est celui de la figure 4.

Il est également possible d'appliquer l'invention à tout type de chaîne d'acquisition analogique dans laquelle on a plusieurs entrées et l'on souhaite sélectionner une seule entrée ayant une fonctionnalité donnée.

A titre d'exemple particulier de réalisation, un interrupteur analogique tel que décrit en figure 3 est dimensionné de la façon suivante.

Pour un transistor à grille interdigitalisée ayant une largeur de grille de 0,13 micromètre, le transistor T1 a quarante doigts de grille, le transistor T2 a dix doigts de grille, les transistors T3 et T4 ont deux doigts de grille, et les transistors T5 et T6 ont cinq doigts de grille. Un tel interrupteur analogique présente, en régime établi, un spectre ayant une première harmonique à 600 MHz proche de 0 dBc, et des harmoniques d'ordres supérieurs inférieures à -70 dBc. On peut donc en déduire que l'interrupteur analogique selon l'invention présente une très bonne linéarité.

Des modes de réalisation particuliers de la présente invention ont été décrits. Diverses variantes et modifications apparaîtront à l'homme de l'art. En particulier, on peut cascader un transistor suiveur supplémentaire au transistor T2, pour asservir la tension grille-source du transistor T1 sur le potentiel de la borne U1. Par ailleurs, l'homme du métier saura adapter l'interrupteur analogique de l'invention dans tout type de circuits. De plus, dans l'exemple de l'invention, un transistor MOS de type N est utilisé. La présente invention s'applique également à des transistors MOS de type P pour lequel la borne de caisson (bulk) est portée à un potentiel correspondant au potentiel le plus élevé des bornes U1 et U2, en inversant les types de transistors ainsi que les bornes d'alimentation.

## Revendications

1. Interrupteur analogique (1) comprenant:
au moins un premier transistor MOS (T1) apte à transférer un signal appliqué sur une première borne (U1) vers une seconde borne (U2) ;
un circuit de connexion (3) pour porter une borne de substrat (B_{T1}) dudit premier transistor (T1) à un potentiel fonction des potentiels des première et seconde bornes (U1, U2), **caractérisé en ce qu'**il comporte :
un circuit d'asservissement (2) comportant un deuxième transistor MOS (T2) comprenant une borne de commande (G_{T2}) connectée à la première borne (U1), une borne de substrat (B_{T2}) et une première borne de conduction (S_{T2}) connectées à une première borne d'alimentation (Vcc) et à une borne de commande (G_{T1}) dudit premier transistor (T1), par l'intermédiaire d'une source de courant constant (Ip), et une deuxième borne de conduction (D_{T2}) connectée à une deuxième borne d'alimentation (Vss).

2. Interrupteur analogique selon la revendication 1, dans lequel le circuit de connexion (3) comporte un troisième (T3) et un quatrième (T4) transistors MOS montés en série entre deux bornes de conduction (S_{T1}) du premier transistor (T1), les troisième (T3) et quatrième (T4) transistors ayant des bornes de commande (G_{T3}, G_{T4}) reliées au circuit d'asservissement (2), et ayant chacun une borne de substrat (B_{T3}, B_{T4}) et au moins une borne de conduction (D_{T3}, S_{T4}) reliées à un premier noeud commun (N1) avec la borne de substrat (B_{T1}) du premier transistor (T1).

3. Interrupteur analogique selon la revendication 1 ou 2, comportant en outre un circuit auxiliaire (4) connecté au circuit d'asservissement pour faire passer l'interrupteur analogique (1) d'un état conducteur à un état bloqué.

4. Interrupteur analogique selon la revendication 3 dans son rattachement à la revendication 2, dans lequel le circuit auxiliaire (4) comprend des cinquième (T5) et sixième (T6) transistors MOS, le cinquième transistor (T5) ayant une première borne de conduction (D_{T5}) connectée audit premier noeud commun (N1), une borne de commande (G_{T5}) reliée à une borne d'entrée (U_OFF) recevant un signal logique, et le sixième transistor (T6) ayant une borne de commande (G_{T6}) reliée à la borne d'entrée (U_OFF) et une première borne de conduction (D_{T6}) reliée au circuit d'asservissement (2).

5. Interrupteur analogique selon l'une quelconque des revendications 1 à 4, comprenant deux premiers transistors (T11, T12) montés en série entre les deux première et seconde bornes (U1, U2) et ayant chacun une borne de commande (G_{T11}, G_{T12}) reliée au circuit d'asservissement (2).

6. Interrupteur analogique selon la revendication 5, dans son rattachement à la revendication 4, dans lequel le circuit auxiliaire (4) comprend un septième transistor MOS (T7) connecté par sa borne de commande (G_{T7}) à la borne d'entrée (U_OFF), par sa première borne de conduction (D_{T7}) à un deuxième noeud commun (PC) aux deux premiers transistors (T11, T12) et par sa deuxième borne de conduction (S_{T7}) à la deuxième borne d' alimentation (Vss).

7. Circuit de commutation analogique (5) de signaux comprenant au moins un interrupteur analogique (1) selon l'une quelconque des revendications 1 à 6, connecté à un convertisseur analogique/numérique.

## Claims

1. An analog switch (1) comprising:
at least one first MOS transistor (T1) capable of transferring a signal applied to a first terminal (U1) to a second terminal (U2);
a connection circuit (3) for bringing a substrate terminal (B_{T1}) of said first transistor (T1) to a voltage which is a function of the voltages of the first and second terminals (U1, U2),
**characterized in that** it comprises:
a control circuit (2) comprising a second MOS transistor (T2) comprising a control terminal (G_{T2}) connected to the first terminal (U1), a substrate terminal (B_{T2}), and a first conduction terminal (S_{T2}) connected to said first supply terminal (Vcc) and a control terminal (G_{T1}) of said first transistor (T1), via a current source (Ip), and a second conduction terminal (D_{T2}) connected to a second supply terminal (Vss).

2. The analog switch of claim 1, wherein the connection circuit (3) comprises a third (T3) and a fourth (T4) MOS transistors series-assembled between two conduction terminals (S_{T1}) of the first transistor (T1), the third (T3) and fourth (T4) transistors having control terminals (G_{T3}, G_{T4}) connected to the control circuit (2), and each having a substrate terminal (B_{T3}, B_{T4}) and at least one conduction terminal (D_{T3}, S_{T4}) connected to a first node (N1) common with a substrate terminal (B_{T1}) of the first transistor (T1).

3. The analog switch of claim 1 or 2, further comprising an auxiliary circuit (4) to have the analog switch (1) pass from an on state to an off state.

4. The analog switch of claims 3 and 2, wherein the auxiliary circuit (4) comprises fifth (T5) and sixth (T6) MOS transistors, the fifth transistor (T5) having a first conduction terminal (D_{T5}) connected to said first common node (N1), a control terminal (G_{T5}) connected to an input terminal (U_OFF) receiving a logic signal, and the sixth transistor (T6) having a control terminal (G_{T6}) connected to the input terminal (U_OFF) and a first conduction terminal (D_{T6}) connected to the control circuit (2).

5. The analog switch of any of claims 1 to 4, comprising two first transistors (T11, T12) series-assembled between the two first and second terminals (U1, U2) and each having a control terminal (G_{T11}, G_{T12}) connected to the control circuit (2).

6. The analog switch of claims 5 and 4, wherein the auxiliary circuit (4) comprises a seventh MOS transistor (T7) connected by its control terminal (G_{T7}) to the input terminal (U_OFF), by its first conduction terminal (D_{T7}) to a second node (PC) common to the two first transistors (T11, T12) and by its second conduction terminal (S_{T7}) to the second supply terminal (Vss).

7. An analog signal switching circuit (5) comprising at least one analog switch (1) of any of claims 1 to 6, connected to an analog-to-digital converter.

## Patentansprüche

1. Ein Analogschalter (1), der folgendes aufweist:
wenigstens einen ersten MOS-Transistor (T1), der in der Lage ist, ein an einen ersten Anschluss (U1) angelegtes Signal zu einem zweiten Anschluss (U2) zu übertragen;
eine Verbindungsschaltung (3) zum Bringen eines Substratsanschlusses (B_{T1}) des ersten Transistors (T1) auf eine Spannung, die eine Funktion der Spannungen der ersten und zweiten Anschlüsse (U1, U2) ist, **dadurch gekennzeichnet, dass** der analoge Schalter Folgendes aufweist:
eine Steuerschaltung (2), die einen zweiten MOS-Transistor (T2) aufweist, der einen Steueranschluss (G_{T2}) aufweist, der mit dem ersten Anschluss (U1) verbunden ist, ein Substratanschluss (B_{T2}) und einen ersten Leitungsanschluss (S_{T2}), der mit dem ersten Versorgungsanschluss (Vcc) und einem Steueranschluss (G_{T1}) des ersten Transistors (T1) verbunden ist, und zwar über eine Stromquelle (Ip) und einen zweiten Leitungsanschluss (D_{T2}), der mit einem zweiten Versorgungsanschluss (Vss) verbunden ist.

2. Analogschalter nach Anspruch 1, wobei die Verbindungsschaltung (3) dritte (T3) und vierte (T4) MOS-Transistoren aufweist, die in Serie angeordnet sind, zwischen den zwei Leitungsanschlüssen (S_{T1}) des ersten Transistors (T1), wobei die dritten (T3) und vierten (T4) Transistoren Steueranschlüsse (G_{T3}, G_{T4}) aufweisen, die mit der Steuerschaltung (2) verbunden sind, und jeweils einen Substratanschluss (B_{T3}, B_{T4}) und wenigstens einen Leitungsanschluss (D_{T3}, S_{T4}) aufweisen, die mit einem ersten Knoten (N1) verbunden sind, und zwar gemeinsam mit einem Substratanschluss (B_{T1}) des ersten Transistors (T1).

3. Analogschalter nach Anspruch 1 oder 2, der ferner eine Hilfsschaltung (4) aufweist, um den Analogschalter (1) von einem Ein-Zustand zu einem Aus-Zustand zu bringen.

4. Analogschalter nach den Ansprüchen 3 und 2, wobei die Hilfsschaltung (4) fünfte (T5) und sechste (T6) MOS-Transistoren aufweist, wobei der fünfte Transistor (T5) einen ersten Leitungsanschluss (D_{T5}) aufweist, der mit dem ersten gemeinsamen Knoten (N1) verbunden ist, einen Steueranschluss (G_{T5}), der mit dem Eingangsanschluss (U_OFF) verbunden ist, der ein Logiksignal empfängt, und wobei der sechste Transistor (T6) einen Steueranschluss (G_{T6}) aufweist, der mit dem Eingangsanschluss (U_OFF) verbunden ist, und einen ersten Leitungsanschluss (D_{T6}), der mit der Steuerschaltung (2) verbunden ist.

5. Analogschalter nach einem der Ansprüche 1 bis 4, der zwei erste Transistoren (T11, T12) aufweist, die in Serie angeordnet sind, zwischen den zwei ersten und zweiten Anschlüssen (U1, U2) und die jeweils einen Steueranschluss (G_{T11}, G_{T12}) aufweisen, der mit der Steuerschaltung (2) verbunden ist.

6. Analogschalter nach den Ansprüchen 5 und 4, wobei die Hilfsschaltung (4) einen siebten MOS-Transistor (T7) aufweist, der über seinen Steueranschluss (G_{T7}) mit dem Eingangsanschluss (U_OFF) verbunden ist, der über seinen ersten Leitungsanschluss (D_{T7}) mit einem zweiten Knoten (PC) verbunden ist, gemeinsam mit den ersten Transistoren (T11, T12) und der über seinen zweiten Leitungsanschluss (S_{T7}) mit dem zweiten Versorgungsanschluss (Vss) verbunden ist.

7. Analogsignalschaltkreis (5), der wenigstens einen Analogschalter (1) nach einem der Ansprüche 1 bis 6 aufweist, der mit einem Analog-zu-Digital-Wandler verbunden ist.
